# EUROPEAN PATENT SPECIFICATION

(11) **EP 4 261 551 B1**
(45) Date of publication and mention of the grant of the patent: **23.07.2025**
(21) Application number: 22167529.1
(22) Date of filing: 11.04.2022
(51) Int. Cl.: G01R 31/327

(54) **A METHOD FOR PREVENTIVE MAINTENANCE OF HMI CONTROLS COMPONENTS**
VERFAHREN ZUR PRÄVENTIVEN WARTUNG VON HMI STEUERUNGSKOMPONENTEN
PROCÉDÉ D'ENTRETIEN PRÉVENTIF DE COMPOSANTS DE COMMANDES D'IHM

(43) Date of publication of application: 18.10.2023
(73) Proprietor: VOLVO TRUCK CORPORATION, 405 08 Göteborg (SE)
(72) Inventor: DE BRITO, David, 38230 CHARVIEU CHAVAGNEUX (FR); BALAIN, Frédéric, 38370 Saint Clair du Rhone (FR)
(74) Representative: Germain Maureau

(56) References cited:
- US-A1- 2003 132 752
- US-A1- 2020 003 838
- US-A1- 2021 181 255

## Description

### TECHNICAL FIELD

The invention relates to a method for preventive maintenance to predict the wearing of Human Machine Interface (HMI) controls components like switches (push buttons, rotary switch, toggle switch, mono or bi-stable switches), levers, freewheels, or other kind of HMI interfaces.

The invention can be applied to HMI controls components in any vehicle comprising a Human Machine Interface, including cars, trucks, buses, military vehicles, tramways, trains, boats, aircrafts, etc... Although the invention will be described with respect to a switch, the invention is not restricted to this particular type of control components, but may also be used for levers, freewheels, or other kind of HMI interfaces.

### BACKGROUND

The technical field of this invention relate to the following context:
- HMI controls components like switches (push buttons, rotary switch, toggle switch, mono or bi-stable switches), levers, freewheels or other kind of HMI interfaces;
- An electronic architecture with Electronic Control Units (ECUs) communicating via LIN bus or CAN bus or hardwired connection and receiving information from HMI controls components;
- An instrument cluster displaying information related to preventive maintenance;
- An off board system (fleet management) receiving logged data from trucks and scheduling specific HMI controls components replacement.

Each technology of HMI controls listed above has its own mechanical behaviour and wearing profile.

Some of the HMI components have important and/or safety functions, like the StartStop button, AutoHold or ESP, and the aim of this invention is to be able to predict the end of life of such components and inform the customer or fleet manager to replace it before unplanned stop or safety situation occurs.

Some key factor that we are able to collect to detect the wearing or degradation of internal mechanism of HMI controls switches:
- Number of actuations;
- loss of redundant contacts;
- degradation of contact resistance value.

The preventive maintenance function is aiming to collect data and log them into ECU memory and build warnings and replacement strategies adapted to each features. Documents D1= US 2021/181255 A1, D2=US 2003/132752 A1, and D3=US 2020/003838 A1 disclose methods to warn on the wearing or degradation of internal mechanism of HMI controls switches.

Today the switches are designed for a specific reliability depending on several variables like:
- number of actuations,
- environmental behaviour (temperature, humidity, vibration)
- strength to activate switch
- electrical and EMC characteristics

But in real life, today we have no way to monitor the real ageing of this HMI controls. Depending on truck usage, each switch can be used in a different way, and each wearing variable can vary from one customer to another.

For example, A Start&Stop Button is designed for a specific number of pushes, and after this limit, we cannot warranty the correct behaviour of the switch, but this switch is involved in a safety function (start the engine) and then cannot fail (ex if we stall on a railroad crossing, it is mandatory to restart the vehicle quickly).

Today, the driver can inform the switch malfunction to the workshop when it is already failing, but he is not able to verify it nor to predict it.

The invention proposed in this document applies to the preventive maintenance function. The invention will allow us to predict the wearing of switches thanks to logs and then build a strategy to warn the customer or fleet manager and advice for replacement for each individual HMI controls components in the truck, bus, or construction equipment.

### SUMMARY

An object of the invention is to provide a method for preventive maintenance of HMI controls components, which method is configured to predict the wearing of such controls components.

The object is achieved by a method to determine a state of health of an electrical control component of a vehicle according to claim 1.

According to these provisions, the advantage is that the state of health of the electrical control component is monitored.

According to one embodiment, the steps are repeated at successive instants of time during a period of time, and the first state of health is based on the value of the first counter and on a duration of the period of time.

According to these provisions, the advantage is that the monitoring of the state of health takes into account a frequency of occurrence of the event determined at the step of determining.

According to one embodiment, the at least one sensor is further configured to measure a resistance of at least two electrical contacts, the method being further characterized by the further steps of :
- measuring, via at least one sensor, the resistance of at least two electrical contacts, at successive instants of time;
- determining an evolution over time of the resistance measured;
- determining a second state of health of the control component based on the evolution over time of the resistance measured.

According to these provisions, the advantage is that the state of health of the electrical control component is better monitored, according to a second aspect.

According to one embodiment, at least one sensor is further configured to measure a strength applied by a user on the control component to activate the control component, the method being further characterized by the further steps of :
- measuring, via at least one sensor, the strength applied by the user on the control component to activate the control component at a number of successive instants of time;
- determining a third state of health of the control component based on the strength measured at successive instants of time.

According to these provisions, the advantage is that the state of health of the electrical control component is better monitored, according to a third aspect.

According to one embodiment, at least one sensor is further configured to determine whether the control component is activated, the method being further characterized by the further steps of :
- determining, via at least one sensor, that the control component is activated;
- incrementing a value of a second counter;
- determining a fourth state of health of the control component based on the value of the second counter.

According to these provisions, the advantage is that the state of health of the electrical control component is better monitored, according to a fourth aspect.

According to one embodiment, the method being further characterized by the further step of determining a fifth state of health based on at least one of the first state of health, the second sate of health, the third state of health, and the fourth state of health.

According to these provisions, the advantage is that the state of health of the electrical control component is better monitored, according to a combination of different aspects. According to one embodiment, the method being further characterized by the further step of:
- comparing one of the first state of health, the second state of health, the third state of health, the fourth state of health, the fifth state of health, with a pre-warning threshold, to obtain a first comparison result;
- trigger a first level action, the step of triggering a first level action being conditioned by the first comparison result.

According to these provisions, the advantage is that the state of health of the electrical control component is planned to be restored.

According to one embodiment, the method is further characterized by the further step of:
- comparing one of the first state of health, the second state of health, the third state of health, the fourth state of health, the fifth state of health, with a critical warning threshold, to obtain a second comparison result;
- trigger a second level action, the step of triggering a second level action being conditioned by the second comparison result.

According to these provisions, the advantage is that the state of health of the electrical control component is restored immediately.

According to one embodiment, the evolution over time of the resistance measured is a time derivation of the resistance measured, said time derivation being compared with a time derivation threshold to obtain a third comparison result, the step of triggering the second level action being conditioned by the third comparison result.

According to one embodiment, wherein the strength measured is compared to a pre-warning strength threshold, to obtain a fourth comparison result, and wherein the strength measured is compared to a critical warning strength threshold to obtain a fifth comparison result, the step of triggering the first level action being conditioned by the fourth comparison result, and the step of triggering the second level action being conditioned by the fifth comparison result.

According to one embodiment, when the condition for triggering the first level of action is realised at the number of successive instants of time, the number of successive instants of time being greater than a first predetermined number, the step of triggering the first level of action is implemented, and/or when said strength measured is greater than the critical strength threshold, and when the condition for triggering the second level of action is realised at the number of successive instants of time, the number of successive instants of time being greater than a second predetermined number, the step of triggering the second level of action is implemented.

According to one embodiment, the first level action is at least one of display a pre-warning alert on a display device for a driver of the vehicle, send a pre-warning alert to a fleet manager to schedule maintenance of the electrical control component.

According to one embodiment, the second level action is at least one of display a critical-warning alert on a display device for a driver of the vehicle, send a critical-warning alert to a fleet manager to have the electrical control component repaired immediately.

According to an embodiment, a nominal fifth state of health has a value of 100%, and the pre-warning threshold has a value comprised between 15% and 25%, preferably a value of 20%.

According to an embodiment, the critical-warning threshold has a value comprised between 5% and 15%, preferably a value of 10 %.

According to other aspects of the invention, the object is achieved by a computer program according to claim 14, and by a computer readable medium according to claim 15, and by an electronic control unit according to claim 16.

Further advantages and advantageous features of the invention are disclosed in the following description and in the dependent claims.

### BRIEF DESCRIPTION OF THE DRAWINGS

With reference to the appended drawings, below follows a more detailed description of embodiments of the invention cited as examples.

In the drawings:
Fig. 1 is a schematic representation of an electrical control component for which its state of health is monitored by an electronic control unit implementing an embodiment of the invention.
Fig. 2 is a graphical representation of an evolution over time of an electrical resistance of a contact of the electrical control component.
Fig. 3 is schematic representation of the sequence of steps of an embodiment of the method according invention.

### DETAILED DESCRIPTION OF EXAMPLE EMBODIMENTS OF THE INVENTION

It is to be understood that the present invention is not limited to the embodiments described above and illustrated in the drawings; rather, the scope of the invention is defined by the appended claims.

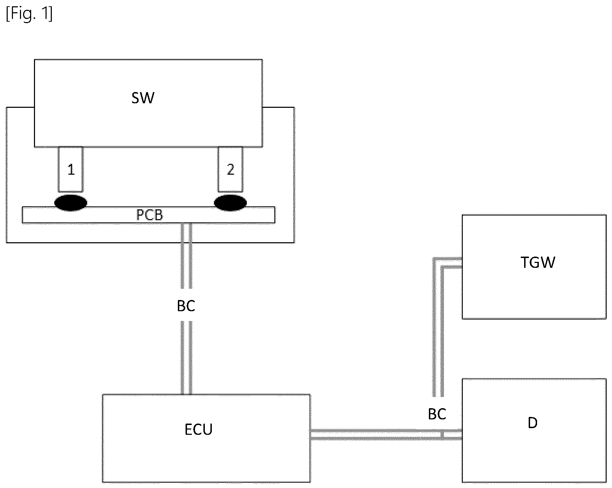

The method is based on several ways to predict the end of life of an electrical control component SW, such as a switch for example as illustrated by figure 1, based on:
1) Logging the number of activations compare to a theoretical value sent by the supplier; and/or
2) detect when one of the internal electronic contacts is failing; and/or,
3) measure the contact resistance value of each switch and compare it to a theoretical curve sent by the supplier; and/or,
4) measure the strength needed to activate the switch which will increase along the switch is ageing and compare it to a theoretical value.

Although the invention will be described with respect to a switch SW, the invention is not restricted to this particular type of control components, but may also be used for levers, freewheels, or other kind of HMI interfaces

The different ways, or cases above, are monitored in an ECU and when one of the cases above is triggered, or a combination of them, then the preventive maintenance function will activate its pre-defined strategy depending on estimated wearing levels.

The different cases above will be explained in reference to figure 1 representing a push switch SW, configured to be pushed to establish a contact at two terminals 1, 2 of the switch with two corresponding poles on a printed circuit board PCB, the printed circuit board PCB being connected, via a communication bus BC, to an Electronic Control Unit ECU, the Electronic Control Unit ECU being itself connected, via the communication bus BC, to a display D and to another equipment, typically Telematic Gateway (TGW) configured to communicate with a fleet management operator.

In Case 1 above, each activation of the push switch PS is detected and logged into a counter in the Electronic Control Unit ECU memory. Initially the switch state of health is considered equal to 100%, as long as the counter increase, it makes the state of health decreasing. The switch state of health will then reach 0% when the theoretical lifetime value sent by the supplier is exceeded.

In Case 2 above, when the push switch PS may have more than one internal contact, as is the case of the push switch PS of figure 1, which has two contacts 1, 2, either because of the mechanical structure of the switch or because of redundancy needs. Each contact is sending the information to the Electronic Control Unit ECU. When the Electronic Control Unit ECU detects that 1 contact is closed but not the other ones, then it is considered as failing. Each time that this phenomena is triggered the switch state of health is reduced by a 5% for example and if it is occurring too often in a period of time (example 3 times in a day) then the switch state of health will automatically be reduced below the critical warning thresholds because we can consider that the end of life is very close.

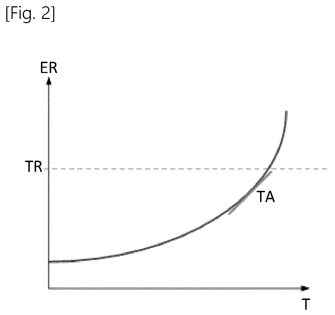

In Case 3 above, thanks to some internal sensors inside the push switch PS it is possible to measure the electrical contact resistance ER of each mechanical contacts. This measurement value can be compared over time and when a significant increase is observed, it corresponds to a close end of life of the switch and then the switch state of health will be automatically decreased under the critical warning thresholds because we can consider that the end of life is very close. For example, as illustrated on figure 2, based on a curve representing the nominal evolution of the electrical resistance ER in ordinates over time T in abscissa, a threshold TR on the value of the electrical resistance ER is determined based on the tangent TA of the curve, so that when the electrical resistance ER becomes higher than the determined threshold TR, the switch state of health will be automatically decreased under the critical warning thresholds because it is considered that the end of life is very close.

In case 4 above, thanks to some other internal sensors inside the push switch PS, it is possible to measure the strength applied by the driver when he pushes the button. Then the strength evolution (to activate the switch) may be compared over time. This measurement value may be compared over time and when it exceeds certain predefined values (2 values corresponding to pre-warning or critical warning) over time (typically stable strength over 10 activation), then the switch state of health will be automatically decreased under the pre-warning or critical warning thresholds (corresponding to the strength measured).

Preventive maintenance according to the invention defines 3 levels strategy:
1) Normal : Switch state of health > pre-warning value: no actions needed, the switch is considered to be fully functional
2) Prewarning: pre warning value >= Switch state of health > critical warning value; then a pre-warning alert is displayed in the instrument cluster and sent to fleet manager to schedule maintenance
3) Critical warning: critical warning >= Switch state of health; then a critical alert is displayed in the instrument cluster and sent to fleet manager to go to workshop immediately

In this strategy, the initial switch state of health is considered 100%, a prewarning level may be 20%, a critical level can be 10%. Each threshold can be set individually depending on switch technology and corresponding feature risk levels.

It is also possible to communicate the estimated remaining percentage of life for each switch via telematics TGW to a fleet management system (or for gold contract maintenance) and give a global overview of upcoming maintenance needed.

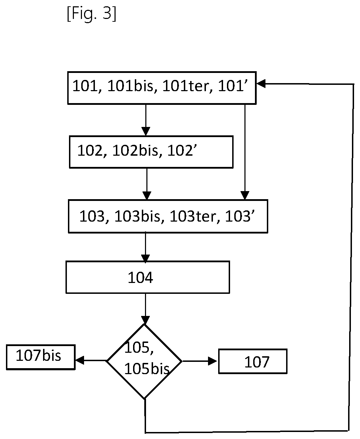

In reference to figure 3 the different steps of an embodiment of the method 100 to determine a state of health of the electrical control component SW of a vehicle, is described herein after; the electrical control component SW comprises at least two electrical contacts 1,2, the at least two electrical contacts 1,2 being configured to be in a closed status when the electrical control component SW is activated, or in an open status when the electrical control component SW is not activated, the electrical component further comprises at least one sensor configured to determine if the status of the at least two contacts is open or closed; the method 100 is implemented by an electronic control unit ECU and is characterized by the steps of :
- determining 101, via at least one sensor, that the status of one of at least two contacts 1, 2 is closed and that another one of at least two contacts (1, 2) is open;
- incrementing 102 a value of a first counter;
- determining 103 a first state of health of the electrical control component (SW) based on the value of the first counter;

In particular, the steps are repeated at successive instants of time during a period of time, and wherein the first state of health is based on the value of the first counter and on a duration of the period of time.

In a second example of implementation of the method 100, the at least one sensor is further configured to measure a resistance of at least two electrical contacts, the method 100 being further characterized by the further steps of :
- measuring 101bis, via the at least one sensor, the resistance of the at least two electrical contacts, at successive instants of time;
- determining 102bis an evolution over time of the resistance measured;
- determining 103bis a second state of health of the control component based on the evolution over time of the resistance measured.

In a third example of implementation of the method 100, the at least one sensor is further configured to measure a strength applied by a user on the control component to activate the control component, the method being further characterized by the further steps of :
- measuring 101ter, via the at least one sensor, the strength applied by the user on the control component to activate the control component at a number of successive instants of time;
- determining 103ter a third state of health of the control component based on the strength measured at successive instants of time.

In a fourth example of implementation of the method 100, the at least one sensor is further configured to determine whether the control component is activated, the method being further characterized by the further steps of :
- determining 101', via the at least one sensor, that the control component is activated;
- incrementing 102' a value of a second counter;
- determining 103' a fourth state of health of the control component based on the value of the second counter.

More particularly, the method 100 comprises a further step of determining 104 a fifth state of health based on at least one of the first state of health, the second sate of health, the third state of health, and the fourth state of health. Thus, the fifth state of health may be a combination of any two or more of the first state of health, the second sate of health, the third state of health, and the fourth state of health.

Even more particularly, the method 100 being further characterized by the further steps of:
- comparing 105 the fifth state of health with a pre-warning threshold and with a critical warning threshold;
- if 106 the fifth state of health is comprised between the pre-warning threshold and the critical warning threshold, trigger 107 a first level action;
- if 106 the fifth state of health is greater than the critical warning threshold, trigger 107bis a second level action.

Optionally, the evolution over time of the resistance measured at step 102bis is a time derivation of the resistance measured, said time derivation being compared with a time derivation threshold, so that when said time derivation is greater than the time derivation threshold the second state of health is set to a value under the critical warning threshold.

According to a further option, the strength measured at step 101ter is compared to a pre-warning strength threshold and to a critical warning strength threshold, so that when said strength measured is comprised between the pre-alert strength threshold and the critical strength threshold, the third state of health is set to a value under the pre-alert warning threshold, and when said strength measured is greater than the critical strength threshold, then the third state of health is set to a value under the critical warning threshold.

More specifically, the strength measured at step 101ter at the number of successive instants of time is successively compared to a pre-warning strength threshold and to a critical warning strength threshold, so that when said strength measured is successively comprised between the pre-alert strength threshold and the critical strength threshold, and when the number of successive instants of time is greater than a predetermined number, the third state of health is set to a value under the pre-alert warning threshold, and when said strength measured is greater than the critical strength threshold, and when the number of successive instants of time is greater than the predetermined number, then the third state of health is set to a value under the critical warning threshold.

For example, the first level action 107 is the action of displaying a pre-warning alert on a display device D for a driver of the vehicle, or sending a pre-warning alert to a fleet manager TGW to schedule maintenance of the electrical control component SW. The second level action 107bis is at least one of display a critical-warning alert on a display device D for a driver of the vehicle, send a critical-warning alert to a fleet manager TGW to have the electrical control component SW repaired immediately.

In particular, a nominal fifth state of health has a value of 100%, and the pre-warning threshold has a value comprised between 15% and 25%, preferably a value of 20 %; the critical-warning threshold has a value comprised between 5% and 15%, preferably a value of 10 %.

According to an aspect, the invention also relates to a computer program comprising program code means for performing the steps described herein above when said program is run on a computer.

According to a further aspect, the invention also relates to a computer readable medium carrying a computer program comprising program code means for performing the steps described herein above when said program product is run on a computer.

According to another aspect, the invention also relates to an electronic control unit ECU for controlling a state of health of an electrical control component SW of a vehicle, the electronic control unit ECU being configured to perform the steps of the method 100 described herein above.

## Claims

1. A method (100) to determine a state of health of an electrical control component (SW) of a vehicle, the electrical control component (SW) comprising at least two electrical contacts (1,2), the at least two electrical contacts (1,2) being configured to be in a closed status when the electrical control component (SW) is activated, or in an open status when the electrical control component (SW) is not activated, the electrical component further comprising at least one sensor configured to determine if the status of at least two contacts is open or closed, the electrical control component (SW) being considered to fail when the status of one of the at least two contacts (1, 2) is closed and the status of another one of the at least two contacts (1, 2) is open, the method being implemented by an electronic control unit (ECU) to determine (103) a first state of health of the electrical control component (SW) based on the value of a first counter,
the method being **characterized by** the steps of:
- determining (101) a failing of the electronic control component (SW), via the at least one sensor, when the status of one of the at least two contacts (1, 2) is closed and another one of the at least two contacts (1, 2) is open;
- incrementing (102) a value of the first counter each time the previous determination step (101) determines a failing of the electronic control component (SW); .

2. A method (100) according to claim 1, wherein the steps are repeated at successive instants of time during a period of time, and wherein the first state of health is based on the value of the first counter and on a duration of the period of time.

3. A method (100) according to claim 1 or 2, wherein the at least one sensor is further configured to measure a resistance of at least two electrical contacts, the method (100) being further **characterized by** the further steps of :
- measuring (101bis), via the at least one sensor, the resistance of at least two electrical contacts, at successive instants of time;
- determining (102bis) an evolution over time of the resistance measured;
- determining (103bis) a second state of health of the control component based on the evolution over time of the resistance measured.

4. A method (100) according to any one of claims 1 to 3, wherein the at least one sensor is further configured to measure a strength applied by a user on the control component to activate the control component, the method being further **characterized by** the further steps of :
- measuring (101ter), via the at least one sensor, the strength applied by the user on the control component to activate the control component at a number of successive instants of time;
- determining (103ter) a third state of health of the control component based on the strength measured at successive instants of time.

5. A method (100) according to any one of claims 1 to 4, wherein the at least one sensor is further configured to determine whether the control component is activated, the method being further **characterized by** the further steps of :
- determining (101'), via the at least one sensor, that the control component is activated
- incrementing (102') a value of a second counter;
- determining (103') a fourth state of health of the control component based on the value of the second counter.

6. A method according to anyone of claims 1 to 5, the method being further **characterized by** the further step of determining (104) a fifth state of health based on at least one of the first state of health, the second sate of health, the third state of health, and the fourth state of health.

7. A method according to anyone of claims 1 to 6, the method being further **characterized by** the further step of:
- comparing (105) one of the first state of health, the second state of health, the third state of health, the fourth state of health, the fifth state of health, with a pre-warning threshold, to obtain a first comparison result;
- trigger (107) a first level action, the step (107) of triggering a first level action being conditioned by the first comparison result.

8. A method according to claim 7, the method being further **characterized by** the further step of:
- comparing (105bis) one of the first state of health, the second state of health, the third state of health, the fourth state of health, the fifth state of health, with a critical warning threshold, to obtain a second comparison result;
- trigger (107bis) a second level action, the step (107bis) of triggering a second level action being conditioned by the second comparison result.

9. A method according to claim 8, as far as it depends on claim 3, wherein the evolution over time of the resistance measured is a time derivation of the resistance measured, said time derivation being compared with a time derivation threshold to obtain a third comparison result, the step (107bis) of triggering the second level action being conditioned by the third comparison result.

10. A method according to anyone of claims 7 or 8, as far as it depends on claim 4, wherein the strength measured is compared to a pre-warning strength threshold, to obtain a fourth comparison result, and wherein the strength measured is compared to a critical warning strength threshold to obtain a fifth comparison result, the step (107) of triggering the first level action being conditioned by the fourth comparison result, and the step (107bis) of triggering the second level action being conditioned by the fifth comparison result.

11. A method according to claim 10, wherein when the condition for triggering (107) the first level of action is realised at the number of successive instants of time, the number of successive instants of time being greater than a first predetermined number, the step of triggering (107) the first level of action is implemented, and/or when said strength measured is greater than the critical strength threshold, and when the condition for triggering (107bis) the second level of action is realised at the number of successive instants of time, the number of successive instants of time being greater than a second predetermined number, the step of triggering (107bis) the second level of action is implemented.

12. A method according to anyone of claims 7 or 11, wherein the first level action (107) is at least one of display a pre-warning alert on a display device (D) for a driver of the vehicle, send a pre-warning alert to a fleet manager (TGW) to schedule maintenance of the electrical control component (SW).

13. A method according to anyone of claims 8 to 11, wherein the second level action (107bis) is at least one of display a critical-warning alert on a display device (D) for a driver of the vehicle, send a critical-warning alert to a fleet manager(TGW) to have the electrical control component (SW) repaired immediately.

14. A computer program comprising program code means for performing the steps of any one of claims 1 to 13 when said program is run on an electronic control unit (ECU).

15. A computer readable medium carrying a computer program comprising program code means for performing the steps of any of claims 1 to 13 when said program product is run on an electronic control unit (ECU).

16. An electronic control unit (ECU) for controlling a state of health of an electrical control component (SW) of a vehicle, the electronic control unit (ECU) being configured to perform the steps of the method (100) according to any of claims 1 to 13.

## Patentansprüche

1. Verfahren (100) zum Bestimmen eines Gesundheitszustands einer elektrischen Steuerkomponente (SW) eines Fahrzeugs, wobei die elektrische Steuerkomponente (SW) mindestens zwei elektrische Kontakte (1, 2) umfasst, wobei die mindestens zwei elektrischen Kontakte (1, 2) so konfiguriert sind, dass sie sich in einem geschlossenen Zustand befinden, wenn die elektrische Steuerkomponente (SW) aktiviert ist, oder in einem geöffneten Zustand, wenn die elektrische Steuerkomponente (SW) nicht aktiviert ist, wobei die elektrische Komponente ferner mindestens einen Sensor umfasst, der so konfiguriert ist, dass er bestimmt, ob der Zustand von mindestens zwei Kontakten offen oder geschlossen ist, wobei die elektrische Steuerkomponente (SW) als ausgefallen angesehen wird, wenn der Zustand eines der mindestens zwei Kontakte (1, 2) geschlossen ist und der Zustand eines anderen der mindestens zwei Kontakte (1, 2) offen ist, wobei das Verfahren von einer elektronischen Steuereinheit (ECU) implementiert wird, um einen ersten Gesundheitszustand der elektrischen Steuerkomponente (SW) basierend auf dem Wert eines ersten Zählers zu bestimmen (103), wobei das Verfahren durch die folgenden Schritte gekennzeichnet ist:
- Bestimmen (101) eines Ausfalls der elektronischen Steuerkomponente (SW) über den mindestens einen Sensor, wenn der Zustand eines der mindestens zwei Kontakte (1, 2) geschlossen ist und ein anderer der mindestens zwei Kontakte (1, 2) offen ist;
- Erhöhen (102) eines Wertes des ersten Zählers jedes Mal, wenn der vorherige Bestimmungsschritt (101) einen Ausfall der elektronischen Steuerkomponente (SW) bestimmt; .

2. Verfahren (100) nach Anspruch 1, wobei die Schritte zu aufeinanderfolgenden Zeitpunkten über einen Zeitraum wiederholt werden, und wobei der erste Gesundheitszustand auf dem Wert des ersten Zählers und auf einer Dauer des Zeitraums basiert.

3. Verfahren (100) nach Anspruch 1 oder 2, wobei der mindestens eine Sensor ferner so konfiguriert ist, dass er einen Widerstand von mindestens zwei elektrischen Kontakten misst, wobei das Verfahren (100) ferner durch die folgenden weiteren Schritte gekennzeichnet ist:
- Messen (101bis), über den mindestens einen Sensor, des Widerstands von mindestens zwei elektrischen Kontakten zu aufeinanderfolgenden Zeitpunkten;
- Bestimmen (102bis) einer zeitlichen Entwicklung des gemessenen Widerstands;
- Bestimmen (103bis) eines zweiten Gesundheitszustands der Steuerkomponente basierend auf der zeitlichen Entwicklung des gemessenen Widerstands.

4. Verfahren (100) nach einem der Ansprüche 1 bis 3, wobei der mindestens eine Sensor ferner so konfiguriert ist, dass er eine Kraft misst, die von einem Benutzer auf die Steuerkomponente ausgeübt wird, um die Steuerkomponente zu aktivieren, wobei das Verfahren ferner durch die folgenden weiteren Schritte gekennzeichnet ist:
- Messen (101ter), über den mindestens einen Sensor, der Kraft, die der Benutzer auf die Steuerkomponente ausübt, um die Steuerkomponente zu einer Anzahl aufeinanderfolgender Zeitpunkte zu aktivieren;
- Bestimmen (103ter) eines dritten Gesundheitszustands der Steuerkomponente basierend auf der an aufeinanderfolgenden Zeitpunkten gemessenen Kraft.

5. Verfahren (100) nach einem der Ansprüche 1 bis 4, wobei der mindestens eine Sensor ferner so konfiguriert ist, dass er bestimmt, ob die Steuerkomponente aktiviert ist, wobei das Verfahren ferner durch die folgenden weiteren Schritte gekennzeichnet ist:
- Bestimmen (101') über den mindestens einen Sensor, dass die Steuerkomponente aktiviert ist;
- Erhöhen (102') eines Wertes eines zweiten Zählers;
- Bestimmen (103') eines vierten Gesundheitszustands der Steuerkomponente basierend auf dem Wert des zweiten Zählers.

6. Verfahren nach einem der Ansprüche 1 bis 5, wobei das Verfahren ferner durch den weiteren Schritt des Bestimmens (104) eines fünften Gesundheitszustands basierend auf mindestens einem des ersten Gesundheitszustands, des zweiten Gesundheitszustands, des dritten Gesundheitszustands und des vierten Gesundheitszustands gekennzeichnet ist.

7. Verfahren nach einem der Ansprüche 1 bis 6, wobei das Verfahren ferner durch den folgenden weiteren Schritt gekennzeichnet ist:
- Vergleichen (105) eines des ersten Gesundheitszustands, des zweiten Gesundheitszustands, des dritten Gesundheitszustands, des vierten Gesundheitszustands und des fünften Gesundheitszustands mit einem Vorwarnschwellenwert, um ein erstes Vergleichsergebnis zu erhalten;
- Auslösen (107) einer ersten Handlungsebene, wobei der Schritt (107) des Auslösens einer ersten Handlungsebene durch das erste Vergleichsergebnis bedingt ist.

8. Verfahren nach Anspruch 7, wobei das Verfahren ferner durch den folgenden weiteren Schritt gekennzeichnet ist:
- Vergleichen (105bis) eines des ersten Gesundheitszustands, des zweiten Gesundheitszustands, des dritten Gesundheitszustands, des vierten Gesundheitszustands und des fünften Gesundheitszustands mit einem kritischen Warnschwellenwert, um ein zweites Vergleichsergebnis zu erhalten;
- Auslösen (107bis) einer zweiten Handlungsebene, wobei der Schritt (107bis) des Auslösens einer zweiten Handlungsebene durch das zweite Vergleichsergebnis bedingt ist.

9. Verfahren nach Anspruch 8, soweit es von Anspruch 3 abhängt, wobei die zeitliche Entwicklung des gemessenen Widerstands eine zeitliche Ableitung des gemessenen Widerstands ist, wobei die zeitliche Ableitung mit einem Schwellenwert für die zeitliche Ableitung verglichen wird, um ein drittes Vergleichsergebnis zu erhalten, wobei der Schritt (107bis) des Auslösens der zweiten Handlungsebene durch das dritte Vergleichsergebnis bedingt ist.

10. Verfahren nach einem der Ansprüche 7 oder 8, soweit es von Anspruch 4 abhängt, wobei die gemessene Kraft mit einem Vorwarnschwellenwert für die kraft verglichen wird, um ein viertes Vergleichsergebnis zu erhalten, und wobei die gemessene Kraft mit einem kritischen Warnschwellenwert für die Kraft verglichen wird, um ein fünftes Vergleichsergebnis zu erhalten, wobei der Schritt (107) des Auslösens der ersten Handlungsebene durch das vierte Vergleichsergebnis bedingt ist, und der Schritt (107bis) des Auslösens der zweiten Handlungsebene durch das fünfte Vergleichsergebnis bedingt ist.

11. Verfahren nach Anspruch 10, wobei, wenn die Bedingung für das Auslösen (107) der ersten Handlungsebene bei der Anzahl aufeinanderfolgender Zeitpunkten realisiert wird, wobei die Anzahl aufeinanderfolgender Zeitinstanzen größer als eine erste vorbestimmte Anzahl ist, der Schritt des Auslösens (107) der ersten Handlungsebene implementiert wird, und/oder wenn die gemessene Kraft größer als der kritische Schwellenwert für die Kraft ist, und wenn die Bedingung für das Auslösen (107bis) der zweiten Handlungsebene bei der Anzahl aufeinanderfolgender Zeitpunkte realisiert wird, wobei die Anzahl aufeinanderfolgender Zeitinstanzen größer als eine zweite vorbestimmte Anzahl ist, der Schritt des Auslösens (107bis) der zweiten Handlungsebene implementiert wird.

12. Verfahren nach einem der Ansprüche 7 oder 11, wobei die erste Handlungsebene (107) das Anzeigen einer Vorwarnmeldung auf einer Anzeigevorrichtung (D) für einen Fahrer des Fahrzeugs und/oder das Senden einer Vorwarnmeldung an einen Flottenmanager (TGW), um die Wartung der elektrischen Steuerkomponente (SW) zu planen, ist.

13. Verfahren nach einem der Ansprüche 8 bis 11, wobei die zweite Handlungsebene (107bis) das Anzeigen einer kritischen Warnmeldung auf einer Anzeigevorrichtung (D) für einen Fahrer des Fahrzeugs und/oder das Senden einer kritischen Warnmeldung an einen Flottenmanager (TGW), um die elektrische Steuerkomponente (SW) sofort reparieren zu lassen, ist.

14. Computerprogramm, das Programmcodemittel zum Durchführen der Schritte nach einem der Ansprüche 1 bis 13 umfasst, wenn das Programm auf einer elektronischen Steuereinheit (ECU) ausgeführt wird.

15. Computerlesbares Medium mit einem Computerprogramm, das Programmcodemittel zum Durchführen der Schritte nach einem der Ansprüche 1 bis 13 umfasst, wenn das Programmprodukt auf einer elektronischen Steuereinheit (ECU) ausgeführt wird.

16. Elektronische Steuereinheit (ECU) zum Steuern eines Gesundheitszustands einer elektrischen Steuerkomponente (SW) eines Fahrzeugs, wobei die elektronische Steuereinheit (ECU) so konfiguriert ist, dass sie die Schritte des Verfahrens (100) nach einem der Ansprüche 1 bis 13 durchführt.

## Revendications

1. Procédé (100) pour déterminer l'état de santé d'un composant de commande électrique (SW) d'un véhicule, le composant de commande électrique (SW) comprenant au moins deux contacts électriques (1, 2), les au moins deux contacts électriques (1, 2) étant configurés pour être dans un état fermé lorsque le composant de commande électrique (SW) est activé, ou dans un état ouvert lorsque le composant de commande électrique (SW) n'est pas activé, le composant électrique comprenant en outre au moins un capteur configuré pour déterminer si l'état des au moins deux contacts est ouvert ou fermé, le composant de commande électrique (SW) étant considéré comme défaillant lorsque l'état de l'un des au moins deux contacts (1, 2) est fermé et que l'état d'un autre des au moins deux contacts (1, 2) est ouvert, le procédé étant mis en œuvre par une unité de commande électronique (ECU) pour déterminer (103) un premier état de santé du composant de commande électrique (SW) sur la base de la valeur d'un premier compteur,
le procédé étant **caractérisé par** les étapes de :
- détermination (101) d'une défaillance du composant de commande électrique (SW), par l'intermédiaire de l'au moins un capteur, lorsque l'état de l'un des au moins deux contacts (1, 2) est fermé et qu'un autre des au moins deux contacts (1, 2) est ouvert ;
- incrémentation (102) d'une valeur du premier compteur à chaque fois que l'étape de détermination précédente (101) détermine une défaillance du composant de commande électrique (SW).

2. Procédé (100) selon la revendication 1, dans lequel les étapes sont répétées à des instants successifs pendant une période de temps, et dans lequel le premier état de santé est basé sur la valeur du premier compteur et sur la durée de la période de temps.

3. Procédé (100) selon la revendication 1 ou 2, dans lequel l'au moins un capteur est en outre configuré pour mesurer une résistance d'au moins deux contacts électriques, le procédé (100) étant en outre **caractérisé par** les étapes supplémentaires de :
- mesure (101bis), par l'intermédiaire de l'au moins un capteur, de la résistance d'au moins deux contacts électriques, à des instants successifs ;
- détermination (102bis) d'une évolution dans le temps de la résistance mesurée ;
- détermination (103bis) d'un deuxième état de santé du composant de commande sur la base de l'évolution dans le temps de la résistance mesurée.

4. Procédé (100) selon l'une quelconque des revendications 1 à 3, dans lequel l'au moins un capteur est en outre configuré pour mesurer une force appliquée par un utilisateur sur le composant de commande pour activer le composant de commande, le procédé étant en outre **caractérisé par** les étapes supplémentaires de :
- mesure (101ter), par l'intermédiaire de l'au moins un capteur, de la force appliquée par l'utilisateur sur le composant de commande pour activer le composant de commande à un certain nombre d'instants successifs ;
- détermination (103ter) d'un troisième état de santé du composant de commande sur la base de la force mesurée à des instants successifs.

5. Procédé (100) selon l'une quelconque des revendications 1 à 4, dans lequel l'au moins un capteur est en outre configuré pour déterminer si le composant de commande est activé, le procédé étant en outre **caractérisé par** les étapes supplémentaires de :
- détermination (101'), par l'intermédiaire de l'au moins un capteur, que le composant de commande est activé ;
- incrémentation (102') d'une valeur d'un second compteur ;
- détermination (103') d'un quatrième état de santé du composant de commande sur la base de la valeur du second compteur.

6. Procédé selon l'une quelconque des revendications 1 à 5, le procédé étant en outre **caractérisé par** l'étape supplémentaire de détermination (104) d'un cinquième état de santé sur la base d'au moins l'un du premier état de santé, du deuxième état de santé, du troisième état de santé et du quatrième état de santé.

7. Procédé selon l'une quelconque des revendications 1 à 6, le procédé étant en outre **caractérisé par** l'étape supplémentaire de :
- comparaison (105) de l'un du premier état de santé, du deuxième état de santé, du troisième état de santé, du quatrième état de santé, du cinquième état de santé, avec un seuil de pré-avertissement, pour obtenir un premier résultat de comparaison ;
- déclenchement (107) d'une action de premier niveau, l'étape (107) de déclenchement d'une action de premier niveau étant conditionnée par le premier résultat de comparaison.

8. Procédé selon la revendication 7, le procédé étant en outre **caractérisé par** l'étape supplémentaire de :
- comparaison (105bis) de l'un du premier état de santé, du deuxième état de santé, du troisième état de santé, du quatrième état de santé, du cinquième état de santé, à un seuil d'avertissement critique, pour obtenir un deuxième résultat de comparaison ;
- déclenchement (107bis) d'une action de second niveau, l'étape (107bis) de déclenchement d'une action de second niveau étant conditionnée par le deuxième résultat de comparaison.

9. Procédé selon la revendication 8, dans la mesure où elle dépend de la revendication 3, dans lequel l'évolution dans le temps de la résistance mesurée est une dérivation temporelle de la résistance mesurée, ladite dérivation temporelle étant comparée à un seuil de dérivation temporelle pour obtenir un troisième résultat de comparaison, l'étape (107bis) de déclenchement de l'action de second niveau étant conditionnée par le troisième résultat de comparaison.

10. Procédé selon l'une quelconque des revendications 7 ou 8, dans la mesure où elle dépend de la revendication 4, dans lequel la force mesurée est comparée à un seuil de force de pré-avertissement, pour obtenir un quatrième résultat de comparaison, et dans lequel la force mesurée est comparée à un seuil de force d'avertissement critique pour obtenir un cinquième résultat de comparaison, l'étape (107) de déclenchement de l'action de premier niveau étant conditionnée par le quatrième résultat de comparaison, et l'étape (107bis) de déclenchement de l'action de second niveau étant conditionnée par le cinquième résultat de comparaison.

11. Procédé selon la revendication 10, dans lequel lorsque la condition de déclenchement (107) du premier niveau d'action est réalisée au nombre d'instants successifs, le nombre d'instants successifs étant supérieur à un premier nombre prédéterminé, l'étape de déclenchement (107) du premier niveau d'action est mise en œuvre, et/ou lorsque ladite force mesurée est supérieure au seuil de force critique, et lorsque la condition de déclenchement (107bis) du second niveau d'action est réalisée au nombre d'instants successifs, le nombre d'instants successifs étant supérieur à un second nombre prédéterminé, l'étape de déclenchement (107bis) du second niveau d'action est mise en œuvre.

12. Procédé selon l'une quelconque des revendications 7 ou 11, dans lequel l'action de premier niveau (107) est au moins l'un parmi l'affichage d'une alerte de pré-avertissement sur un dispositif d'affichage (D) pour un conducteur du véhicule, l'envoi d'une alerte de pré-avertissement à un gestionnaire de parc automobile (TGW) pour planifier la maintenance du composant de commande électrique (SW).

13. Procédé selon l'une quelconque des revendications 8 à 11, dans lequel l'action de second niveau (107bis) est au moins l'un parmi l'affichage d'une alerte d'avertissement critique sur un dispositif d'affichage (D) pour un conducteur du véhicule, l'envoi d'une alerte d'avertissement critique à un gestionnaire de parc automobile (TGW) pour faire réparer immédiatement le composant de commande électrique (SW).

14. Programme informatique comprenant des moyens de code de programme pour effectuer les étapes de l'une quelconque des revendications 1 à 13 lorsque ledit programme est exécuté sur une unité de commande électronique (ECU).

15. Support lisible par ordinateur portant un programme informatique comprenant des moyens de code de programme pour effectuer les étapes de l'une des revendications 1 à 13 lorsque ledit produit de programme est exécuté sur une unité de commande électronique (ECU).

16. Unité de commande électronique (ECU) pour contrôler l'état de santé d'un composant de commande électrique (SW) d'un véhicule, l'unité de commande électronique (ECU) étant configurée pour effectuer les étapes du procédé (100) selon l'une des revendications 1 à 13.
